# EUROPEAN PATENT APPLICATION

(11) **EP 2 173 004 A1**
(43) Date of publication of application: **07.04.2010**
(21) Application number: 08791076.6
(22) Date of filing: 11.07.2008
(51) Int. Cl.: H01M 14/00, H01L 31/04

(54) **PHOTOELECTRIC CONVERSION ELEMENT AND METHOD FOR MANUFACTURING THE SAME**

(30) Priority: 12.07.2007 JP 2007183327
(71) Applicant: Hitachi Zosen Corporation, Osaka-shi, Osaka 559-8559 (JP)
(72) Inventor: INOUE, Tetsuya, Osaka-shi Osaka 559-8559 (JP); SUGIYO, Takeshi, Osaka-shi Osaka 559-8559 (JP)
(74) Representative: Paul, Dieter-Alfred
(86) International application number: PCT/JP2008/062546
(87) International publication number: WO 2009/008495

(57) **Abstract**

The present invention provides a photoelectric conversion element having a high power generation efficiency, raising no problem of corrosion, and being applicable to a substrate having a low heat resistance, as well as a method of producing the same. Two sheets of photocatalyst electrodes (10) constructed by forming a photocatalyst film (8) dyed with a photosensitizing dye on one surface of a transparent substrate (1) via a transparent conductive film (2) are disposed to oppose each other. A counter electrode (11) is disposed between these electrodes. The counter electrode is constructed in such a manner that, via a conductive adhesive agent layer (7) that covers the whole of the non-opening parts on both surfaces of a counter electrode substrate (4) having a plurality of openings (9), a brush-shaped carbon nanotube (5) that is oriented substantially perpendicularly to the substrate surface is disposed.

## Description

### TECHNICAL FIELD

The present invention relates to a photoelectric conversion element such as a solar battery and further to a method of producing the same.

### BACKGROUND ART

Generally, a photoelectric conversion element such as a dye-sensitized type solar battery is made of an electrode constructed by forming a transparent conductive film on a transparent substrate such as a glass plate and dyeing the conductive film with a photosensitizing dye, a counter electrode constructed by forming a transparent conductive film on a substrate for the counter electrode, and an electrolyte solution allowed to intervene between the two electrodes.

In the dye-sensitized type solar battery, electrons are excited from the photosensitizing dye on the electrode by optical energy such as solar light. However, not all of the photosensitizing dye receives the optical energy, so that optical energy that passes through the electrode as it is also exists.

Therefore, a dye-sensitized type solar battery is proposed in which the optical energy having passed through the electrode is allowed to contribute to the power generation so as to increase the amount of power generation per unit area by laminating at least two layers of photoelectric conversion layers made by sequentially laminating an electrode layer, a semiconductor layer made of metal oxide having adsorbed a photosensitizing dye, an electrolyte layer, and an electrode layer, with a light-transmitting insulating substrate sandwiched therebetween (See Patent Document 1).
Patent Document 1: Japanese Unexamined Patent Publication (JP-A) No. 11-273753

### DISCLOSURE OF THE INVENTION

### PROBLEMS TO BE SOLVED BY THE INVENTION

However, in the above dye-sensitized type solar battery, it is essential that the electrode (positive electrode) on the insulating member side between the photoelectric conversion layers is made of a conductive layer having a transmittance property in order to transmit the optical energy to the photoelectric conversion layer of the later stage. These conductive layers are constructed by forming a tin oxide layer doped with fluorine on one surface of a transparent glass plate. However, there arises a problem in that these conductive layers will be corroded by being exposed to the electrolyte solution containing a corrosive substance such as iodine.

Therefore, the present invention provides a dye-sensitized type solar battery with increased power generation amount per unit area without raising a problem of corrosion as described above, as well as a method of producing the same.

### MEANS FOR SOLVING THE PROBLEMS

The present invention provides a photoelectric conversion element wherein
two sheets of reference electrodes constructed by forming a photocatalyst film dyed with a photosensitizing dye on one surface of a transparent substrate via a transparent conductive film are disposed to oppose each other,
a counter electrode is disposed between these reference electrodes, and
the counter electrode is constructed in such a manner that, via a conductive adhesive agent layer that covers the whole of the non-opening parts on both surfaces of a counter electrode substrate having a plurality of openings, a brush-shaped carbon nanotube that is oriented substantially perpendicularly to the substrate surface is disposed.

In the photoelectric conversion element according to the present invention, the reference electrode is preferably constructed by allowing a brush-shaped carbon nanotube disposed substantially perpendicularly to the substrate surface on the transparent conductive film on the transparent substrate to carry photocatalyst particles, and dyeing the particles with a photosensitizing dye.

The reference electrode is preferably constructed by forming a photocatalyst film made of a mixture of carbon nanotube particles and photocatalyst particles on the transparent conductive film on the transparent substrate, and dyeing the photocatalyst film with a photosensitizing dye.

The reference electrode may be in contact with the brush-shaped carbon nanotube of the counter electrode.

A method of producing a photoelectric conversion element according to the present invention includes:
constructing a reference electrode by forming a photocatalyst film dyed with a photosensitizing dye on one surface of a transparent substrate via a transparent conductive film;
disposing two sheets of the obtained electrode to oppose each other; and
disposing a counter electrode between these reference electrodes, the counter electrode being constructed in such a manner that, via a conductive adhesive agent layer that covers the whole of the non-opening parts on both surfaces of a counter electrode substrate having a plurality of openings, a brush-shaped carbon nanotube that is oriented substantially perpendicularly to the substrate surface is disposed.

In the method of producing a photoelectric conversion element according to the present invention, the reference electrode is constructed by forming a transparent conductive film on one surface of a transparent substrate, transcribing a separately formed brush-shaped carbon nanotube onto the conductive film in such a manner that the brush-shaped carbon nanotube may be oriented substantially perpendicularly to the substrate surface, allowing the carbon nanotube to carry photocatalyst particles, and dyeing the particles with a photosensitizing dye.

The reference electrode is preferably constructed by forming a transparent conductive film on one surface of a transparent substrate, forming a photocatalyst film made of a mixture of carbon nanotube particles and photocatalyst particles on the conductive film, and dyeing the catalyst film with a photosensitizing dye.

In forming a photocatalyst film made of a mixture of carbon nanotube particles and photocatalyst particles on the transparent conductive film, a paste containing the mixture is preferably applied onto the transparent conductive film, followed by drying. In this case, in applying the paste onto the transparent conductive film, the application is preferably carried out in a state in which an electrostatic field is formed between the transparent conductive film and an electrode opposing thereto.

In the present invention, the transparent substrate of the reference electrode may be a glass plate, a plastic plate, or the like. The transparent conductive film of the reference electrode is preferably a thin film containing, for example, a conductive metal oxide such as tin-added indium oxide [Indium Tin Oxide (TIN)], fluorine-added tin oxide [Fluorine doped Tin Oxide (FTO)], or tin oxide [SnO₂].

The photosensitizing dye may be, for example, a ruthenium complex or an iron complex having a ligand containing a bipyridine structure, a terpyridine structure, or the like, a metal complex of porphyrin series or phthalocyanine series, or further an organic dye such as eosine, rhodamine, merocyanine, or coumalin.

The photocatalyst may be a metal oxide such as titanium oxide (TiO₂), tin oxide (SnO₂), tungsten oxide (WO₃), zinc oxide (ZnO), or niobium oxide (Nb₂O₅).

The substrate for the counter electrode is made of a metal sheet such as aluminum, copper, or tin.

The conductive adhesive agent layer of the counter electrode may be made of a carbon-series conductive adhesive agent, but is not limited thereto.

In accordance with the needs, an electrolyte solution may be allowed to intervene between the reference electrode serving as the negative electrode and the counter electrode serving as the positive electrode. The electrolyte solution may be one in which an electrolyte component such as iodine, iodide ion, or tertiary-butylpyridine is dissolved in an organic solvent such as ethylene carbonate or methoxyacetonitrile.

The formation and the transcription of the brush-shaped carbon nanotube is carried out in accordance with known methods.

### EFFECTS OF THE INVENTION

According to the present invention, since the counter electrode disposed between the two sheets of reference electrodes has a plurality of openings, the optical energy that has not contributed to the power generation in the reference electrode of the previous stage can be guided to the reference electrode of the later stage by passing through the plurality of openings, and can be used here for power generation.

Also, the whole of the non-opening parts on both surfaces of the counter electrode substrate having a plurality of openings are covered with a conductive adhesive agent layer. Therefore, even if an electrolyte solution containing a corrosive substance is allowed to intervene between the two reference electrodes, the electrolyte solution is not brought into contact with the substrate, so that the counter electrode substrate is not corroded by the electrolyte solution.

Further, since the movement of electrons is improved by the brush-shaped carbon nanotube of the counter electrode and the carbon nanotube contained in the photocatalyst, a highly efficient dye-sensitized solar battery can be constructed even with a smaller amount of electrolyte solution as compared with a conventional case.

This can construct a solar battery cell having a high electric power conversion efficiency and being provided with a counter electrode excellent in corrosion resistance.

### BEST MODES FOR CARRYING OUT THE INVENTION

Next, in order to describe the present invention specifically, some Examples of the present invention will be given.

### EXAMPLE 1

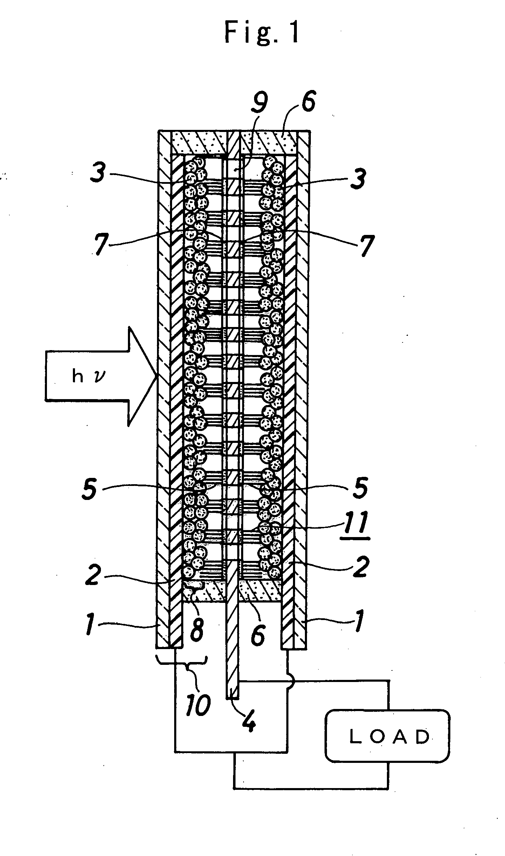

In Fig. 1, a transparent conductive film (2) was formed on one surface of a transparent substrate (1) for an electrode made of glass or plastics. A photocatalyst film (8) made of titanium oxide particles (3) was formed to a thickness of 10 to 15 µm on the conductive film (2). The photocatalyst film (8) was formed by applying a paste containing titanium oxide particles having an average particle size of 20 to 30 nm onto the transparent substrate (1), followed by sintering.

After the photocatalyst film (8) was dyed with a ruthenium series dye referred to as "N3" or "N719", an iodine series electrolyte solution was applied onto the surface of the photocatalyst film (8). In this manner, a photocatalyst electrode (negative electrode) (10) was constructed. Two sheets of the photocatalyst electrodes (10) were prepared.

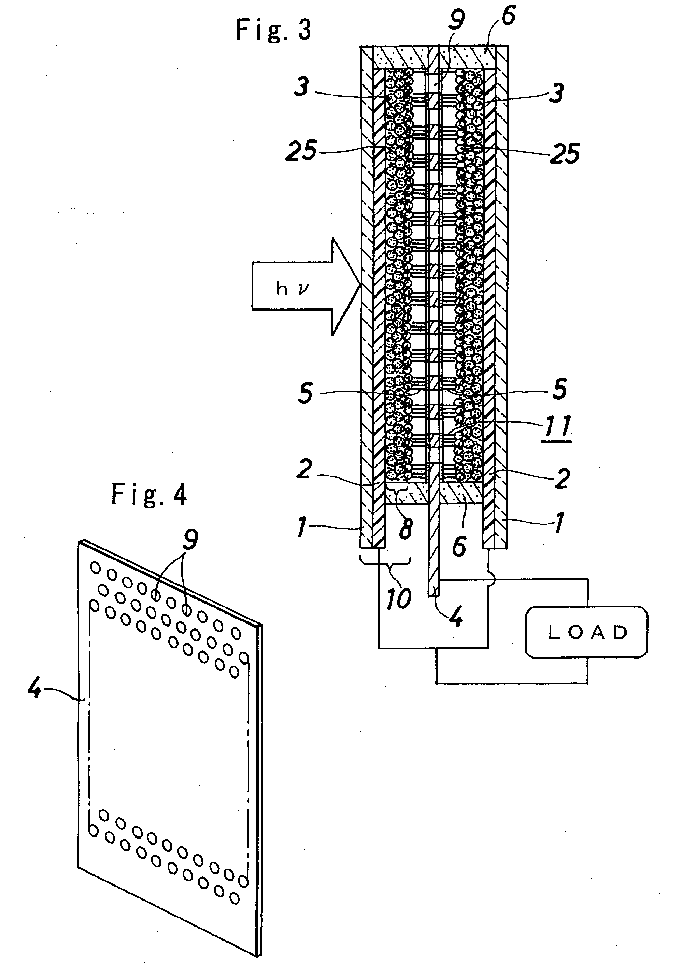

In Fig. 4, a plurality of openings (9) were provided by etching on a metal sheet (4) (for example, an aluminum sheet) having a thickness of 30 to 50 µm. A carbon series conductive adhesive agent was applied onto both surface of the sheet, so as to form a conductive adhesive agent layer (7) that covers the whole of the non-opening parts on both surfaces of the metal sheet. Separately, a carbon nanotube formed substantially perpendicularly to a base material by a method such as the thermochemical vapor deposition method or the plasma chemical vapor deposition method was transcribed from the base material to the non-opening parts on both surfaces of the porous metal sheet (4) via the conductive adhesive agent layer (7) so that the carbon nanotube would be oriented substantially perpendicularly, thereby to form a counter electrode (positive electrode) (11), and an iodine series electrolyte solution was applied onto the surface (counter electrode surface) of a carbon nanotube film (5).

Two sheets of the photocatalyst electrodes (negative electrodes) (10) were disposed to oppose each other, and the counter electrode (positive electrode) (11) having a plurality of openings (9) was disposed between these negative electrodes so that the photocatalyst film (8) of the former would face the carbon nanotube film (5) of the latter. A sealing piece (6) made of thermosetting resin or photosetting resin was allowed to intervene between the peripheries of the three sheets of electrodes, and these electrodes were integrated with the sealing piece (6), thereby to construct a dye-sensitized solar battery cell.

On this cell construction, the electric power conversion efficiency was measured by standard light source radiation of AM 1.5 and 100 mW/cm², with a result that the conversion efficiency was 7.0%. (In a conventional dye-sensitized solar battery cell, the electric power conversion efficiency was about 4 to 5%.)
The generated voltage was about 0.44 V; however, as the optical current density, 16 mA/cm² which will be about 1.4 times as large as that of an ordinary cell was obtained, with a result that the electric power conversion efficiency was improved.

In addition, the corrosiveness by the iodine series electrolyte solution applied onto the surface of the counter electrode was examined. As a result thereof, it was confirmed that the counter electrode surface did not change from the initial state, and is excellent in durability.

### EXAMPLE 2

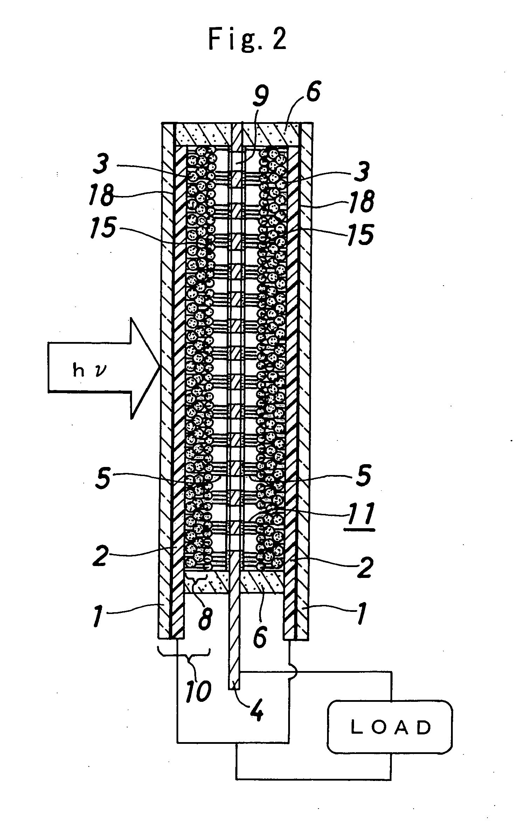

In Fig. 2, to a transparent substrate (1) made of glass or plastics whose surface is covered with a transparent conductive film (18) such as ITO, a transparent conductive film (2) of conductive polymer such as PEDOT or PEDOT/PSS was formed on this transparent conductive film. Separately, a carbon nanotube formed substantially perpendicularly to a base material by a method such as the thermochemical vapor deposition method or the plasma chemical vapor deposition method was transcribed from the base material to the transparent conductive film (2) so that the carbon nanotube would be oriented substantially perpendicularly. The carbon nanotube film (15) had a thickness of about 8 µm.

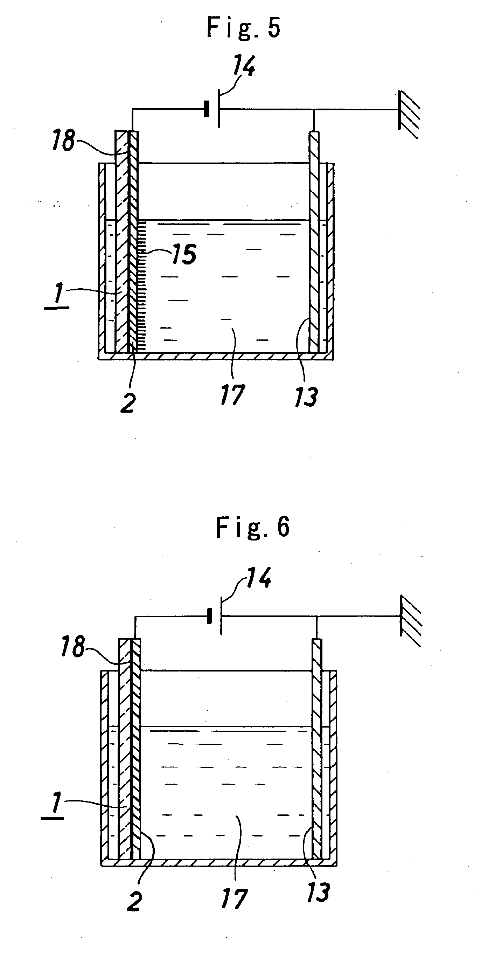

Next, as shown in Fig. 5, the substrate (1) with this carbon nanotube film (15) was immersed into a dispersion liquid (preferably an alcohol dispersion liquid) (17) in which titanium oxide particles (having an average particle size of 20 nm) were dispersed. An electric field of about -1 kV/cm was formed by a high-voltage power source (14) between an electrode (13) disposed in the liquid (17) to oppose to the substrate (1) and the conductive film (2) of the substrate (1), whereby the titanium oxide particles (3) were moved into the carbon nanotube film (15) by the electrophoresis method so as to be carried. Here, the two are connected so that the conductive film (2) side of the substrate (1) will be a negative high voltage, and the electrode (13) side will be grounded.

After a photocatalyst film (8) made of the carbon nanotube film (15) and the titanium oxide particles (3) carried thereon was dyed with a ruthenium series dye referred to as "N3" or "N719", an iodine series electrolyte solution was applied onto the surface of the photocatalyst film (8). In this manner, a photocatalyst electrode (10) was constructed.

Instead of the electrophoresis method, after a solution of chloride or hydroxide which will be a precursor of a photocatalyst is applied onto the substrate (1) with the carbon nanotube film, the carbon nanotube film surface can be allowed to carry predetermined photocatalyst particles by oxidizing the precursor with use of water vapor or the like. Alternatively, the carbon nanotube surface can be allowed to carry photocatalyst particles by dropping, drying, and sintering a dilution liquid obtained by diluting a paste containing a photocatalyst such as titanium oxide particles having an average particle size of 20 to 30 nm with alcohol or the like.

A counter electrode (positive electrode) (11) was formed in the same manner as in Example 1.

Two sheets of the photocatalyst electrodes (negative electrodes) (10) were disposed to oppose each other, and the counter electrode (positive electrode) (11) having the plurality of openings (9) was disposed between these negative electrodes so that the photocatalyst film (8) of the former would face the carbon nanotube film (5) of the latter. A sealing piece (6) made of thermosetting resin or photosetting resin was allowed to intervene between the peripheries of the three sheets of electrodes, and these electrodes were integrated with the sealing piece (6), thereby to construct a dye-sensitized solar battery cell. The inside of the cell was impregnated with an iodine series electrolyte solution.

On this cell construction, the electric power conversion efficiency was measured by standard light source radiation of AM 1.5 and 100 mW/cm², with a result that the conversion efficiency was 7.8%.

### EXAMPLE 3

In Fig. 3, a transparent conductive film (2) was formed on one surface of a transparent substrate (1) for an electrode made of glass or plastics.

Separately, a paste was prepared by mixing titanium oxide photocatalyst particles (having an average particle size of 20 nm) and particles of carbon nanotube (multi-wall nanotube (MWNT)) having a length of 1 µm (those obtained by dispersing MWNT into alcohol, finely grinding with use of a supersonic cleaner, and taking out MWNT of 1 µm or less with use of a filter), and adding alcohol and water to this mixture. In this Example, MWNT was used as the carbon nanotube; however, a single wall nanotube (SWNT) or a double wall nanotube (DWNT) may be used as well.

This paste was applied onto the transparent conductive film (2) on the transparent substrate (1) with use of a doctor blade to form a film, which was then dried at a temperature of 150°C, so as to form a photocatalyst film (8) containing titanium oxide particles (3) and carbon nanotube particles (25). Thereafter, an iodine series electrolyte solution was applied onto the surface of the photocatalyst film (8). In this manner, a photocatalyst electrode was constructed.

In this Example, the film was formed by using a paste containing titanium oxide particles (3) and carbon nanotube particles (25). Alternatively, the film can be formed by the electrophoresis method by diluting the above paste liquid, immersing the substrate (1) with the transparent conductive film (2) into this dilution liquid, and forming an electric field of about -1 kV/cm on the substrate side. In other words, in Fig. 6, to a transparent substrate (1) made of glass or plastics whose surface is covered with a transparent conductive film (18) such as ITO, a transparent conductive film (2) of conductive polymer such as PEDOT or PEDOT/PSS was formed on this transparent conductive film. This transparent substrate (1) was immersed into a dispersion liquid (preferably an alcohol dispersion liquid) (17) in which titanium oxide particles (3) and carbon nanotube particles (25) were dispersed. An electric field of about -1 kV/cm was formed by a high-voltage power source (14) between an electrode (13) disposed in the liquid (17) to oppose to the substrate (1) and the conductive film (2) of the substrate (1), thereby to form a photocatalyst film (8) containing the titanium oxide particles (3) and the carbon nanotube particles (25) by the electrophoresis method. Here, the two are connected so that the conductive film (2) side of the substrate (1) will be a negative high voltage, and the electrode (13) side will be grounded.

After the photocatalyst film (8) was dyed with a ruthenium series dye referred to as "N3" or "N719", an iodine series electrolyte solution was applied onto the surface of the photocatalyst film (8). In this manner, a photocatalyst electrode (10) was constructed.

A counter electrode (positive electrode) (11) was formed in the same manner as in Example 1.

Two sheets of the photocatalyst electrodes (negative electrodes) (10) were disposed to oppose each other, and the counter electrode (positive electrode) (11) having a plurality of openings (9) was disposed between these negative electrodes so that the photocatalyst film (8) of the former would face the carbon nanotube film (5) of the latter. A sealing piece (6) made of thermosetting resin or photosetting resin was allowed to intervene between the peripheries of the three sheets of electrodes, and these electrodes were integrated with the sealing piece (6), thereby to construct a dye-sensitized solar battery cell. The inside of the cell was impregnate with an iodine series electrolyte solution.

On this cell construction, the electric power conversion efficiency was measured by standard light source radiation of AM 1.5 and 100 mW/cm², with a result that the conversion efficiency was 7.2 to 7.4%.

### EXAMPLE 4

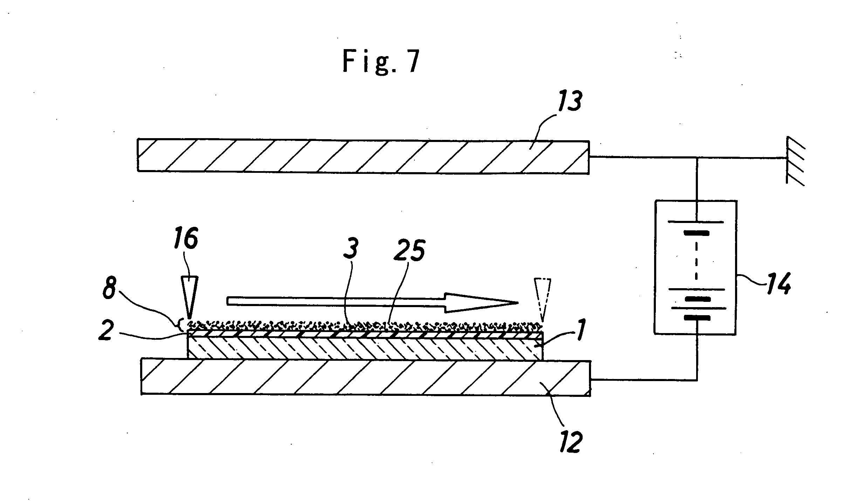

In Fig. 7, a transparent substrate (1) for an electrode made of glass substrate or plastics whose surface is covered with a transparent conductive film (2) such as ITO was disposed on an electrode (12) made of metal plate to which a high-voltage power source (14) was connected. A counter electrode (13) made of metal plate was disposed to face this substrate (1). A negative high voltage was applied between these electrodes (12) (13) to form an electrostatic field. Here, the two are connected so that the electrode (12) side will be a negative high voltage, and the counter electrode (13) side will be grounded.

In this Example, an electric field of -1.5 to -2 kV/cm was formed between the electrodes.

In this state, a paste containing a mixture of a photocatalyst such as titanium oxide particles (3) and carbon nanotube particles (25) finely ground by a supersonic cleaner was applied onto the transparent electrode film. Further, the paste was extended with use of a doctor blade (16) formed by a spatula made of resin so that the paste surface would be uniform, thereby to form a coating film.

The carbon nanotube particles contained in a dispersion form in this coating film will move to the substrate (1) side by the electrostatic field formed between the electrodes, or will be aligned in a perpendicular direction to the substrate (1) surface in the photocatalyst layer. Here, no problem is raised even if the dispersed carbon nanotube particles are tilted slightly in an oblique direction without being oriented completely in the perpendicular direction to the substrate (1) surface.

In this state, the wet coating film was dried by warm wind or hot wind from the outside, and was sintered to form a photocatalyst film (8) containing titanium oxide particles (3) and carbon nanotube particles (25) on the transparent conductive film (2) on the substrate (1).

After the photocatalyst film (8) was dyed with a ruthenium series dye referred to as "N3" or "N719", an iodine series electrolyte solution was applied onto the surface of the photocatalyst film (8). In this manner, a photocatalyst electrode was constructed.

In this Example, the film thickness at the time of paste application was about 100 µm, and the film thickness of the photocatalyst layer (8) after drying and sintering was about 10 µm.

A counter electrode (positive electrode) (11) was formed in the same manner as in Example 1.

A dye-sensitized solar battery cell was constructed in the same manner as in Example 1 from the photocatalyst electrode (negative electrode) and the counter electrode (positive electrode).

On this cell construction, the electric power conversion efficiency was measured by standard light source radiation of AM 1.5 and 100 mW/cm², with a result that the conversion efficiency was 6.5 to 6.8%.

### BRIEF DESCRIPTION OF THE DRAWINGS

[FIG. 1] Fig. 1 is a cross-sectional view illustrating a solar battery cell according to Example 1.
[FIG. 2] Fig. 2 is a cross-sectional view illustrating a solar battery cell according to Example 2.
[FIG. 3] Fig. 3 is a cross-sectional view illustrating a solar battery cell according to Example 3.
[FIG. 4] Fig. 4 is a perspective view illustrating a metal sheet having a plurality of openings.
[FIG. 5] Fig. 5 is a cross-sectional view illustrating the electrophoresis method in Example 2.
[FIG. 6] Fig. 6 is a cross-sectional view illustrating a method of forming a photocatalyst layer by the electrophoresis method in Example 3.
[FIG. 7] Fig. 7 is a cross-sectional view illustrating a method of forming a photocatalyst layer by the electrostatic method in Example 4.

### DESCRIPTION OF REFERENCE NUMERALS

- (1): transparent substrate
- (2) (18): transparent conductive film
- (3): titanium oxide particles
- (4): substrate for counter electrode
- (5) (15): carbon nanotube film
- (6): sealing piece
- (7): conductive adhesive agent layer
- (8): photocatalyst film
- (9): opening
- (10): photocatalyst electrode (reference electrode or negative electrode)
- (11): counter electrode (positive electrode)
- (12)(13): electrode
- (14): high-voltage power source
- (15): carbon nanotube film
- (16): doctor blade
- (17): dispersion liquid
- (25): carbon nanotube particles

## Claims

1. A photoelectric conversion element wherein
two sheets of reference electrodes constructed by forming a photocatalyst film dyed with a photosensitizing dye on one surface of a transparent substrate via a transparent conductive film are disposed to oppose each other,
a counter electrode is disposed between these reference electrodes, and
the counter electrode is constructed in such a manner that, via a conductive adhesive agent layer that covers the whole of the non-opening parts on both surfaces of a counter electrode substrate having a plurality of openings, a brush-shaped carbon nanotube that is oriented substantially perpendicularly to the substrate surface is disposed.

2. The photoelectric conversion element according to claim 1, wherein the reference electrode is constructed by allowing a brush-shaped carbon nanotube disposed substantially perpendicularly to the substrate surface on the transparent conductive film on the transparent substrate to carry photocatalyst particles, and dyeing the particles with a photosensitizing dye.

3. The photoelectric conversion element according to claim 1, wherein the reference electrode is constructed by forming a photocatalyst film made of a mixture of carbon nanotube particles and photocatalyst particles on the transparent conductive film on the transparent substrate, and dyeing the photocatalyst film with a photosensitizing dye.

4. The photoelectric conversion element according to claim 3, wherein the reference electrode is in contact with the brush-shaped carbon nanotube of the counter electrode.

5. A method of producing a photoelectric conversion element comprising:
constructing a reference electrode by forming a photocatalyst film dyed with a photosensitizing dye on one surface of a transparent substrate via a transparent conductive film;
disposing two sheets of the obtained reference electrode to oppose each other; and
disposing a counter electrode between these reference electrodes, the counter electrode being constructed in such a manner that, via a conductive adhesive agent layer that covers the whole of the non-opening parts on both surfaces of a counter electrode substrate having a plurality of openings, a brush-shaped carbon nanotube that is oriented substantially perpendicularly to the substrate surface is disposed.

6. The method of producing a photoelectric conversion element according to claim 5, wherein the reference electrode is constructed by forming a transparent conductive film on one surface of a transparent substrate, transcribing a separately formed brush-shaped carbon nanotube onto the conductive film in such a manner that the brush-shaped carbon nanotube may be oriented substantially perpendicularly to the substrate surface, allowing the carbon nanotube to carry photocatalyst particles, and dyeing the particles with a photosensitizing dye.

7. The method of producing a photoelectric conversion element according to claim 5, wherein the reference electrode is constructed by forming a transparent conductive film on a transparent substrate, forming a photocatalyst film made of a mixture of carbon nanotube particles and photocatalyst particles on the conductive film, and dyeing the photocatalyst film with a photosensitizing dye.

8. The method of producing a photoelectric conversion element according to claim 7, wherein, in forming a photocatalyst film made of a mixture of carbon nanotube particles and photocatalyst particles on the transparent conductive film, a paste containing the mixture is applied onto the transparent conductive film, followed by drying.

9. The method of producing a photoelectric conversion element according to claim 8, wherein, in applying the paste onto the transparent conductive film, the application is carried out in a state in which an electrostatic field is formed between the transparent conductive film and the reference electrode opposing thereto.
